# EUROPEAN PATENT SPECIFICATION

(11) **EP 0 410 464 B1**
(45) Date of publication and mention of the grant of the patent: **28.09.1994**
(21) Application number: 90114389.1
(22) Date of filing: 26.07.1990
(51) Int. Cl.: G11C 29/00, G11C 11/409, G01R 19/165

(54) **Semiconductor memory device having diagnostic circuit for memory cells**
Halbleiterspeichergerät mit Diagnoseschaltung für Speicherzellen
Dispositif de mémoire à semiconducteur comportant un circuit de diagnostic pour cellules de mémoire

(30) Priority: 27.07.1989 JP 195458/89
(43) Date of publication of application: 30.01.1991
(73) Proprietor: NEC CORPORATION, Tokyo (JP)
(72) Inventor: Sugibayashi, Tadahiko, C/o NEC Corporation, Tokyo (JP)
(74) Representative: Glawe, Delfs, Moll & Partner

(56) References cited:
- US-A- 4 393 475
- JEE JOURNAL OF ELECTRONIC ENGINEERING vol. 26, no. 268, April 1989,TOKYO, JAPAN pages 71 - 74; TOSHIO TAKESHIMA ET AL: 'A 55nsec 16Mbit DRAMDEVELPOED BY NEC HAS A BUILT IN SELF-TEST FUNCTION'
- IEEE TRANSACTIONS ON INSTRUMENTATION AND MEASUREMENT vol. 38, no. 3,June 1989, NEW YORK, USA pages 773 - 778; M. JACOMINO ET AL.: 'FAULT DETECTION IN CMOS CIRCUITS BY CONSUMPTION MEASURENENT"
- 1986 INTERNATIONAL TEST CONFERENCE PROCEEDINGS 8 August 1986, WASHINGTON, USApages 140 - 144; G.G. FREEMAN ET AL.: 'TWO CMOS METASTABILITY SENSORS'
- ICCD 88 3 October 1988, NEW YORK, USApages 454 - 457; D.B.I. FELTHAM ET AL: 'CURRENT SENSING FOR BUILT-IN TESTING OFCMOS CIRCUITS'

## Description

### FIELD OF THE INVENTION

This invention relates to a semiconductor memory device and, more particularly, to a diagnostic circuit incorporated in the semiconductor memory device.

### DESCRIPTION OF THE RELATED ART

For rejection of inferior products, semiconductor memory devices are subjected to a diagnostic operation prior to delivery from the factory. In the diagnostic operation, all of the memory cells are examined to see whether the individual memory cells are perfect or defective, and, for this reason, time period consumed per a chip is increased with the integration density.

The disclosure JEE Journal of Electronic Engineering Vol. 26, no. 268, April 1989, Tokyo Japan, pages 71-74; Toshio Takeshima et al.: "A 55nsec 16M-bit DRAM Developed by NEC has a Built-in Self-Test Function", discloses a memory circuit having a buit-in self-test function. The DRAM enters into the self-test mode by a C̅A̅S̅ before R̅A̅S̅ signal sequence with a low W̅E̅ signal and a high test enable (TE) signal. The test ends when all test-pattern generations and comparisons have been completed.

The disclosure IEEE Transactions on Instrumentation and Measurement Vol. 38, no. 3, June 1989, New York, USA, pages 773-778; N.Jacomino et al.: "Fault Detection in CMOS Circuits by Consumption Measurement" discloses a means for testing CMOS circuits by measuring the current consumption of the circuit.

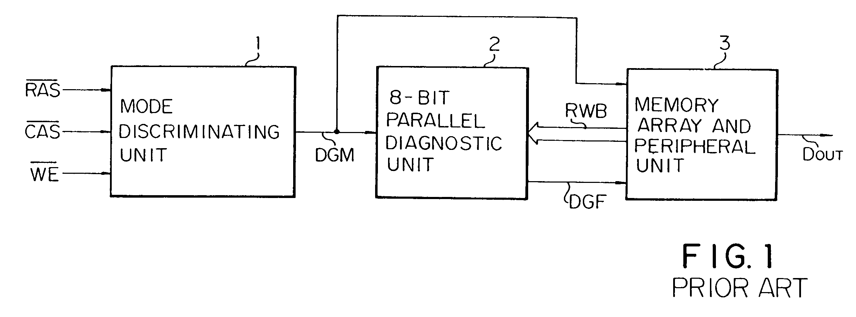

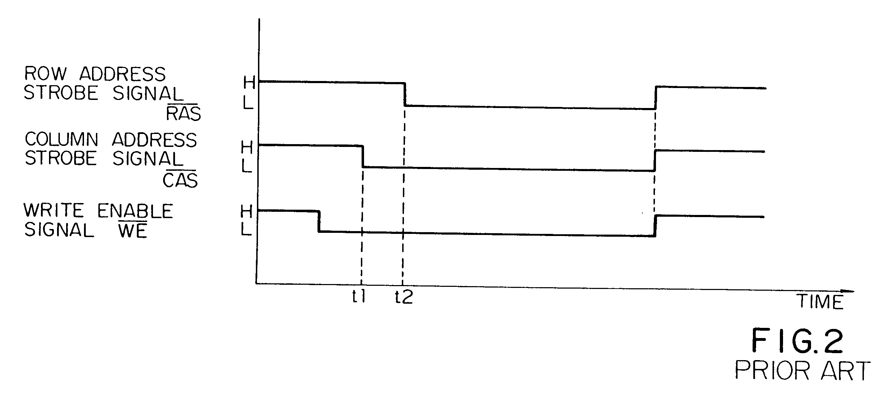

One of the approaches for decreasing the time period is a built-in diagnostic circuit a typical example of which is illustrated in Fig. 1. The diagnostic circuit shown in Fig. 1 is incorporated in a 4 mega-bit dynamic random access memory device and comprises a mode discriminating unit 1, an eight-bit parallel diagnostic unit 2 and a memory cell array associated with peripheral units 3. The mode discriminating unit 1 is supplied with a row address strobe signal R̅A̅S̅, a column address strobe signal C̅A̅S̅ and a write enable signal W̅E̅, and a diagnostic mode of operation is requested at a C̅A̅S̅-before-R̅A̅S̅ refresh timing in the presence of the write enable signal W̅E̅ of an active low voltage level. Namely, the column address strobe signal C̅A̅S̅ is shifted to the active low voltage level at time t1, and the row address strobe signal R̅A̅S̅ enters the active low voltage level at time t2 as shown in Fig. 2. Such a sequential potential decline results in the C̅A̅S̅-before-R̅A̅S̅ refresh timing. If the write-in enable signal W̅E̅ has been already shifted to the active low voltage level, the mode discriminating unit 1 acknowledges the request for the diagnostic mode of operation and allows a diagnostic mode signal DGM to go up to an active high voltage level. The diagnostic mode signal DGM is supplied in parallel to the eight-bit parallel diagnostic unit 2 and the memory cell array 3. With the diagnostic mode signal DGM, the eight-bit diagnostic unit 2 is activated, and data bits are sequentially read out from the memory cell array 3. The data bits are transferred from the memory cell array 3 to the eight-bit parallel diagnostic unit 2 through an eight-bit read-and-write bus RWB, and every eight data bits are simultaneously examined to see whether any one of the eight data bits is indicative of a defect or not. Since a data bit of a predetermined logic level has been written into all of the memory cells, the eight-bit parallel diagnostic unit 2 decides that the semiconductor memory device is of the inferior product upon discrepancy between the eight data bits and shifts a fail signal DGF to the active high voltage level. With the fail signal DGF, one of the peripheral units associated with the memory cell array 3 allows a data output terminal Dout to enter the high impedance state. The data output terminal Dout is monitored from the outside during the diagnostic operation, and the high impedance state tells of the defect found through the diagnostic operation.

The prior art diagnostic technology decreases the amount of time consumed for the diagnostic operation. In fact, the eight bit parallel diagnostic unit 2 shrinks the time period to a eighth of that achieved by a single bit diagnostic unit. However, assuming now that a semiconductor memory device is increased in the integration density n times larger than a previous generation, the number of items to be examined is generally n² times larger than that of the previous generation. For this reason, the eight bit parallel diagnostic unit 2 is less effective to a semiconductor memory device of the next generation.

In this situation, the inventor analyzes the diagnostic items to see what item consumes a relatively long time and why that item consumes the time. The inventor finds that a diagnostic item referred to as "the maximum cycle time" is of the time consuming item. In fact, the 4-mega bit dynamic random access memory device guarantees the maximum cycle time of 10 micro-second which is fifty times longer than the minimum cycle time. However, the memory cell array is innocent of any defect on the time consuming, but some peripheral units associated with the memory cell array directly concern it.

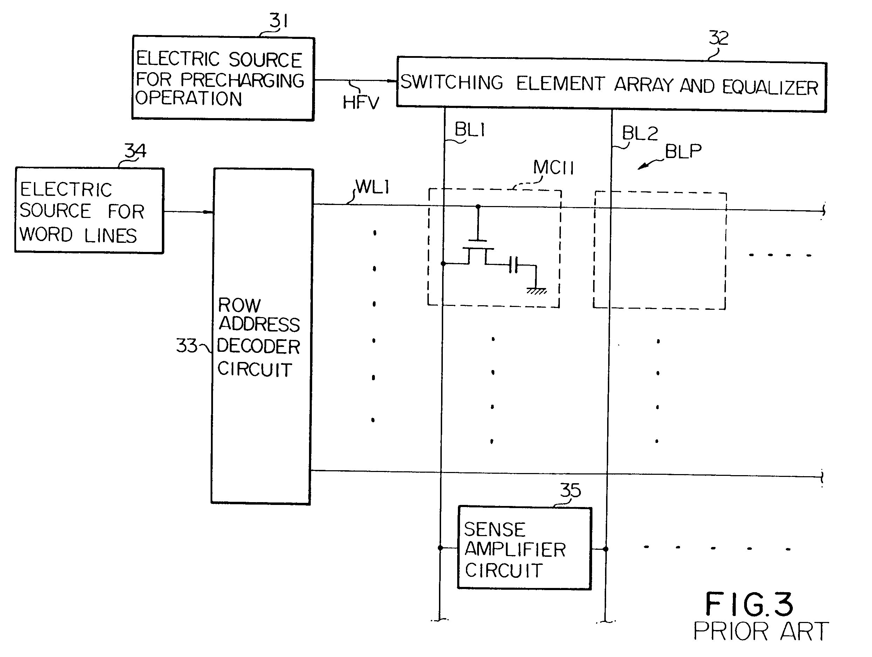

In detail, Fig. 3 shows an essential part of the prior art dynamic random access memory device shown in Fig. 1 in an enlarged scale. The memory cell array incorporated in the dynamic random access memory device consists of a large number of, typically four million one hundred and ninety thousand, bits, and the memory cells are of the one-transistor and one-capacitor type. One of the memory cells is abbreviated as "MC11" and coupled to a bit line pair BLP consisting of a bit line BL1 and a dummy bit line BL2. An electric source 31 is coupled through a power line HFV to a switching element array and equalizer 32 which precharge and balance bit line pairs including the bit line pair BLP. The memory cell array is further coupled to word lines including a word line WL1, and the word lines are selectively driven by a row address decoder circuit 33 coupled to an electric source 34. The bit line pair BLP is coupled to a sense amplifier circuit 35, and the sense amplifier circuit 35 increases a difference in voltage level between the bit line Bl1 and the dummy bit line BL2 for quick decision.

A failure in the diagnostic operation on the maximum cycle time frequently results from a short circuiting between the power line HFV and another conductive node (not shown). In the minimum cycle time, the short circuiting is hardly found because the bit line pair BLP is well balanced due to the electric charges discharged upon the equalization. In fact, the bit line pair BLP is maintained in a predetermined intermediate voltage level over the minimum cycle time regardless of the short circuit between the power line HFV and the conductive node. However, if the short circuiting allows current more than that of the electric source 31 to flow, the intermediate voltage level fluctuates and the sense amplifier circuit 35 fails in the differential amplification. This failure is detected by the eight-bit discriminating unit 1, and the dynamic random access memory device is rejected as an inferior product. However, such a defect is not detectable in every examination of the maximum cycle time, because the memory cells contain irregularity. Some memory cells make the defect be detectable, but another memory cell covers the defect. For this reason, the diagnostic operation on the maximum cycle time should be repeated for all of the memory cells. This prolongs the time period for the diagnostic operation. Moreover, in order to guarantee the maximum cycle time of 10 micro-second, each examination should be carried out over a prolonged time period such as, for example, 12 micro-second. If an examination over 10 micro-second hardly detects the defect of the power line HFV, the defect is detectable in the examination over 12 micro-second. In view of reliability, every examination should be carried out over a prolonged time period, and this further increases the time period for the diagnostic operation. However, some minor defects are hardly detectable through the diagnostic operation on the maximum cycle time. This results in deterioration of the reliability.

Another defect detectable in the maximum cycle time resides in the electric source 34. The word lines are driven at a predetermined high voltage level, and the predetermined high voltage level is produced through a bootstrapping. The defect in the electric source 34 is hardly detectable in a diagnostic operation on the minimum cycle time due to the bootstrapped high voltage level but is detectable in the diagnostic operation on the maximum cycle time. The same problem is encountered in the diagnostic operation as described hereinbefore.

In summary, the prior art diagnostic technology has problems in a prolonged time period consumed in the diagnostic operation and in a reliability of the diagnostic technology.

### SUMMARY OF THE INVENTION

It is therefore an important object of the present invention to provide a semiconductor memory device which has a built-in diagnostic unit merely consuming a relatively short time period without any deterioration of reliability.

To accomplish these objects, the present invention proposes to directly compare voltage levels at predetermined points in a semiconductor memory device with respective standard values in a diagnostic mode of operation.

In accordance with the present invention, there is provided a semiconductor memory device having a usual mode of operation and a diagnostic mode of operation for detecting a defective portion, comprising: a) a diagnostic mode discriminating unit responsive to external control signals indicative of a request for the diagnostic mode of operation and for producing first and second activation signals; b) a memory cell array having a plurality of memory cells and an associated plurality of peripheral units for carrying out the usual mode and the diagnostic mode of operation, the memory cells storing respective data bits, the peripheral units having a conductive portion having a voltage level, which voltage level is liable to be affected by a defect; c) a multi-bit parallel diagnostic unit responsive to the first activation signal and for causing the memory cell array associated with the peripheral units to sequentially supply a plurality of data bit groups each consisting of a predetermined number of the data bits thereto for detecting a defective portion having an influence on the data bits; and d) voltage level examining means responsive to the second activation signal and for comparing the voltage level at the conductive portion with a reference voltage range to see whether or not said defect takes place.

### BRIEF DESCRIPTION OF THE DRAWINGS

The features and advantages of a semiconductor memory device according to the present invention will be more clearly understood from the following description taken in conjunction with the accompanying drawings in which:
Fig. 1 is a block diagram showing the arrangement of a prior art dynamic random access memory device with a built-in diagnostic unit;
Fig. 2 is a diagram showing the waveforms of essential control signals supplied to the prior art dynamic random access memory device;
Fig. 3 is a block diagram showing the arrangement of an essential part of the prior art dynamic random access memory device;
Fig. 4 is a block diagram showing the arrangement of a semiconductor memory device according to the present invention;
Fig. 5 is a diagram showing the waveforms of control signals fed to the diagnostic mode discriminating unit incorporated in the semiconductor memory device shown in Fig. 4;
Fig. 6 is a block diagram showing the arrangement of an essential part of the semiconductor memory device shown in Fig. 4;
Fig. 7 is a block diagram showing the arrangement of an examining circuit incorporated in the semiconductor memory device shown in Fig. 4;
Fig. 8 is a circuit diagram showing the arrangement of an upper bound level setting section or a lower bound level setting section incorporated in the examining circuit; and
Fig. 9 is a block diagram showing another semiconductor memory device according to the present invention.

### DESCRIPTION OF THE PREFERRED EMBODIMENTS

### First Embodiment

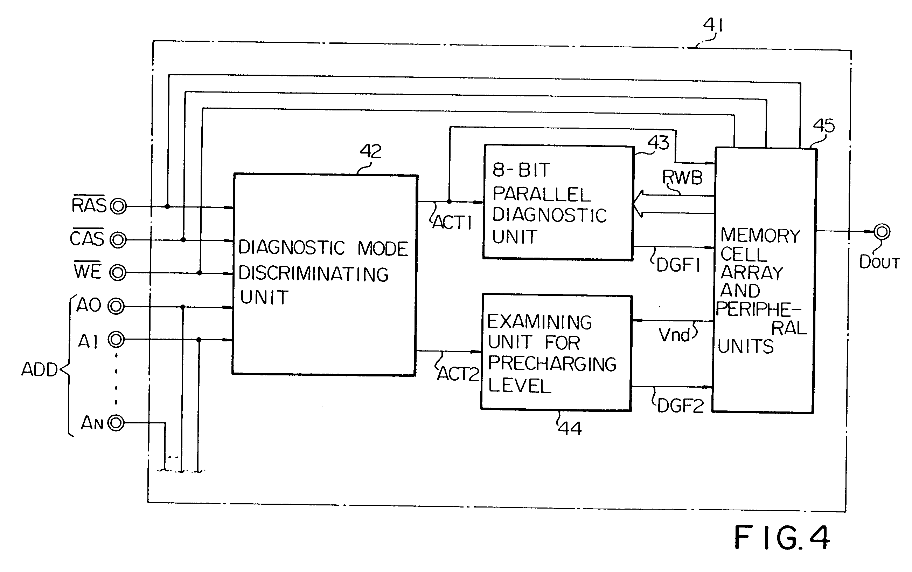

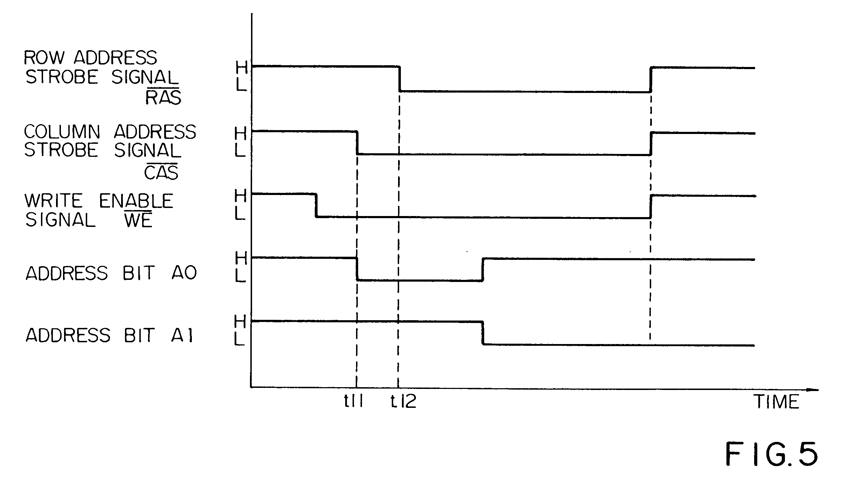

Referring first to Fig. 4 of the drawings, a dynamic random access memory device embodying the present invention is fabricated on a semiconductor chip 41 and comprises a diagnostic mode discriminating unit 42, an eight-bit parallel diagnostic unit 43, an examining unit for precharging level 44 and a memory cell array associated with peripheral units 45. The diagnostic mode discriminating unit 42 is supplied with a row address strobe signal R̅A̅S̅, a column address strobe signal C̅A̅S̅, a write enable signal W̅E̅ and two address bits A0 and A1 of an address signal ADD, and discriminates a diagnostic mode of operation at the C̅A̅S̅-before-R̅A̅S̅ refresh timing in the presence of the write enable signal W̅E̅ of an active low voltage level. Namely, if the column address signal C̅A̅S̅ previously went down to the active low voltage level at time t11 and, then, the row address strobe signal R̅A̅S̅ follows at time t12, the diagnostic mode discriminating unit 42 acknowledges a request for a diagnostic operation in the presence of the write enable signal W̅E̅ of the active low voltage level at time t12 as shown in Fig. 5. The diagnostic mode discriminating unit 42 selectively drives first and second activation signals ACT1 and ACT2 depending upon a combination of the address bits A0 and A1. Namely, if the address bit A0 remains in the low voltage level and the address bit A1 goes up to the high voltage level, the diagnostic mode discriminating unit 42 shifts only the second activation signal ACT2 to the active level and allows the examining unit 44 to carry out an examination for a precharging level as described hereinlater. However, if both of the address bits A0 and A1 are in the high voltage level, the diagnostic mode discriminating unit 42 drives not only the first activation signal ACT1 but also the second activation signal ACT2 to the active level.

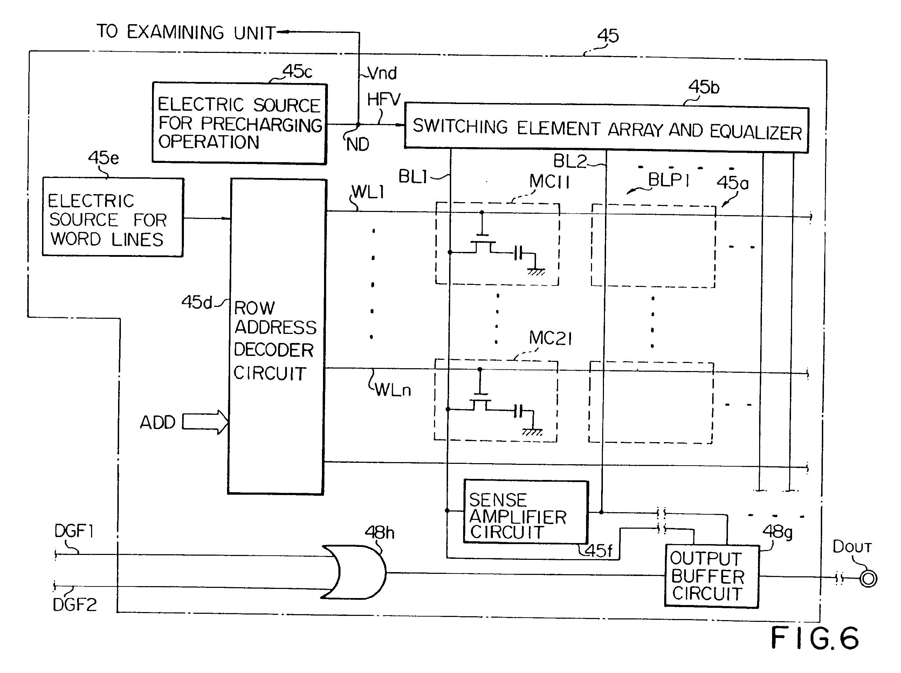

Turning to Fig. 6 of the drawings, the memory cell array 45a has a plurality of memory cells, and only two memory cells are designated by MC11 and MC21, respectively. All of the memory cells are of the type having one-transistor and one-capacitor, and a plurality of bit lines including bit lines BL1 and BL2 are coupled to the memory cells. The bit lines are precharged and balanced by a combined circuit 45b of a switching element array and an equalizer, and the switching element array provides and blocks current paths between an electric source 45c and the bit lines. A current path between the electric source 45c and the switching element array is designated by a reference mark HFV. The memory cells are further coupled to a plurality of word lines WL1 to WLn, and the word lines WL1 to WLn are selectively driven by a row address decoder circuit 45d. An electric source 45e is coupled to the row decoder circuit 45d and supplies a high voltage produced through a bootstrapping to the row address circuit 45d. When the row address decoder circuit 45d drives one of the word lines WL1 to WLn, data bits are read out from the memory cells coupled to the selected word line to the bit lines.

The bit line BL1 is paired with the bit line BL2 to form a bit line pair BLP1, and other bit lines are also paired with one another to form bit line pairs. A sense amplifier circuit 45f is coupled to the bit line pair BLP1, and the other bit line pairs are also coupled to sense amplifier circuits (not shown). The sense amplifier circuit 45f increases a small difference in voltage level between the bit lines BL1 and BL2 for quick determination in logic level. The other sense amplifier circuits behaves as similar to the sense amplifier circuit 45f. One of the data bits thus determined in logic level is transferred through a suitable selector circuit to a tri-state output buffer circuit 48g, and the tri-state output buffer circuit 48g drives a data pin Dout depending upon the logic level of the selected data bit. The tri-state output buffer circuit 48g is associated with an OR gate 48h, and the OR gate 48h allows the data pin Dout to enter a high impedance stated The memory cell array 45a is further associated with various peripheral units or circuits; however, no further description is incorporated hereinbelow because such units and circuits are well known.

The dynamic random access memory device shown in Fig. 4 selectively enter a diagnostic mode of operation and a usual mode of operation, i.e. a read-out mode of operation and a write-in mode of operation. However, description for the usual mode of operation is omitted because of similarity to the prior art dynamic random access memory device.

The eight bit parallel diagnostic unit 43 is similar to those of the dynamic memory device shown in Fig. 1. Namely, the first activation signal ACT1 is supplied in parallel to the eight-bit parallel diagnostic unit 43 and the memory cell array associated with the peripheral units 45. With the first activation signal ACT1, the eight-bit diagnostic unit 43 is activated, and data bits are sequentially read out from the memory cell array 45a. The data bits are transferred from the memory cell array 45a to the eight-bit parallel diagnostic unit 43 through an eight-bit read-and-write bus RWB, and every eight data bits are simultaneously examined to see whether any one of the eight data bits is indicative of a defect or not. Since a data bit of a predetermined logic level has been written into all of the memory cells, the eight-bit parallel diagnostic unit 2 decides that the dynamic random access memory device is of the inferior product upon discrepancy between the eight data bits and shifts a first fail signal DGF1 to the active high voltage level. The first fail signal DGF1 is relayed through the OR gate 48h to the tri-state output buffer circuit 48g, and the tri-state output buffer circuit 48g allows the data pin Dout to enter the high impedance state. The data pin Dout is monitored from the outside during the diagnostic operation, and the high impedance state tells of the defect found through the diagnostic operation.

The examining unit for precharging level 44 is responsive to the second activation signal ACT2 and checks a voltage level Vnd at a node ND on the power line HFV to see whether or not any variation takes place. If a defect has an influence on the precharging voltage level on the bit line pair BLP1, the voltage level Vnd at the node ND is different from a standard level. The examining circuit 44 notices the defect taking place through comparison of the voltage level Vnd with reference voltage signals Ref1 and Ref2 indicative of an acceptable range, and shifts a second fail signal DGF2 to an active level. The second fail signal DGF2 passes through the OR gate 48h and reaches the tri-state output buffer circuit 48g. With the second fail signal DGF2, the tri-state output buffer circuit 48g allows the data pin Dout to enter the high impedance state. Then, the external monitor recognizes the defect, and, accordingly, the dynamic random access memory device is rejected as a inferior product. A typical example of the defect having an influence on the precharging level is a short circuiting in the electric source 45c, however, various defects are detectable through monitoring the voltage level Vnd in so far as the precharging voltage level reaches the defective point.

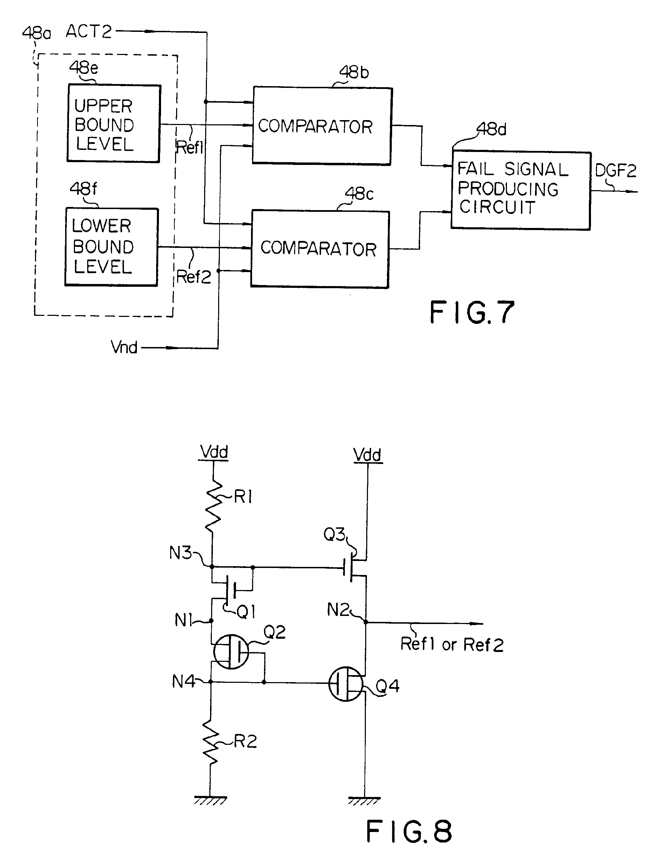

Fig. 7 shows the arrangement of the examining circuit 44 comprising a reference signal producing circuit 48a, two comparators 48b and 48c and a fail signal producing circuit 48d. The reference signal producing circuit 48a has an upper bound level setting section 48e for producing the reference signal Ref1 indicative of the upper bound value of the acceptable range, and a lower bound level setting section 48f for producing the reference signal Ref2 indicative of the lower bound value of the acceptable range. In this instance, the fail signal producing circuit is implemented by an OR gate.

Each of the upper bound level setting section 48e and the lower bound level setting section 48f is arranged as shown in Fig. 8 and comprises a first series combination of a first resistor R1, second and third field effect transistors Q1 and Q2 and a second resistor R2 coupled between a source of positive voltage level Vdd and a ground node, and a second series combination of third and fourth field effect transistors Q3 and Q4 coupled between the source of positive voltage level Vdd and the ground node. The first and second field effect transistors are an n-channel type, but the second and fourth field effect transistors Q2 and Q4 are a p-channel type. The voltage level at a node N1 is adjustable by selecting the resistances of the first and second resistors R1 and R2, and the voltage level at the node N1 is relayed to a node N2, because gate voltage levels at nodes N3 and N4 are shared between the n-channel type field effect transistors Q1 and Q3 and between the n-channel type field effect transistors Q2 and Q4, respectively. The second series combination is larger in current driving capability than the first series combination, and, for this reason, the reference signal Ref1 or Ref2 is large enough for the comparator 48b or 48c. The ratio of the first resistor R1 to the second resistor R2 is different between the upper bound level setting section 48e and the lower bound setting section 48f, and, accordingly, the reference signals Ref1 and Ref2 are different in voltage level from one another.

In the diagnostic mode of operation, the comparators 48b and 48c are activated in the presence of the second activation signal ACT2 and compares the voltage level Vnd with the reference signals Ref1 and Ref2, respectively. If the voltage level Vnd is higher than the reference signal Ref1 or lower than the reference signal Ref2, the voltage level Vnd is out of the acceptable range, and, accordingly, the fail signal producing circuit 48d shifts the second fail signal DGF2 to the active level.

The electric source 45c has the same circuit arrangement as the upper bound level setting section 48e or the lower bound level setting section 48f, and any short circuiting is such a circuit arrangement is causative of the variation of the precharging voltage level.

The examining circuit 48 thus arranged is effective in decreasing the time period for the diagnostic operation as well as in enhancing the reliability of the dynamic random access memory device. If the examining circuit 48 is activated with the address bits A0 and A1 of the high voltage level, any defect with influence on the precharging level is directly detected within an extremely short time period. Such a quick detection speeds up the diagnostic operation. Since the variation in the precharging voltage level is directly detected, the diagnostic operation enhances the reliability of the dynamic random access memory device. Moreover, only a single examination is enough for the diagnostic operation on the precharging voltage level, because the variation in precharging voltage level is independent of the memory cells and the sense amplifier circuits. If the random access memory device is of the four-mega bit type, the diagnostic operation is decreased to an extremely short time period which is one five hundred thousandth of that consumed by the prior art four-mega bit dynamic random access memory device.

### Second Embodiment

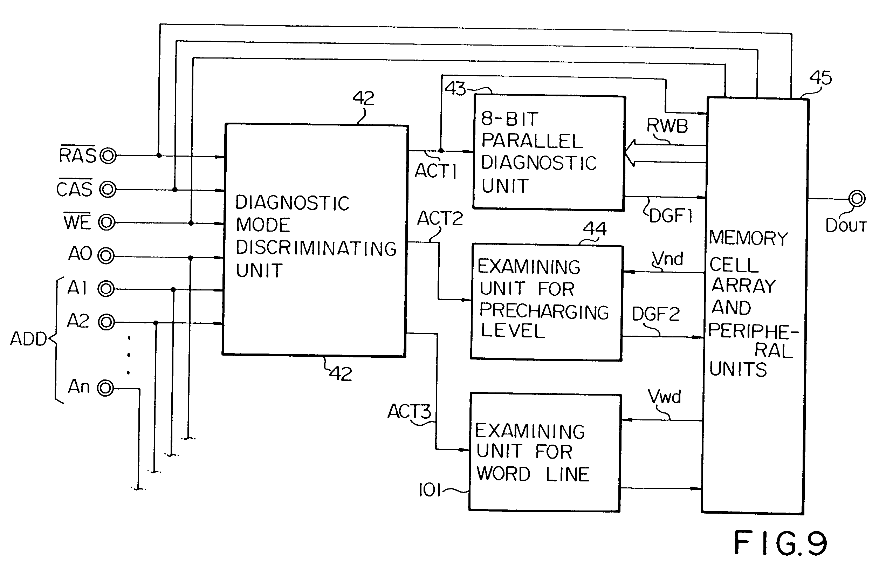

Turning to Fig. 9 of the drawings, another dynamic random access memory device is illustrated and has all of the component units 42, 43, 44 and 45 of the dynamic random access memory device shown in Fig. 4. The diagnostic mode discriminating unit 42 produces not only the first and second activation signals ACT1 and ACT2 but also a third activation signal ACT3 depending upon a combination of address bits A0, A1 and A2. The dynamic random access memory device shown in Fig. 9 further comprises another examining unit 101 which examines a voltage level Vwd on the word lines WL1 to WLn in the presence of the third activation signal ACT3. If a defect takes place in the electric source 45e by way of example, the voltage level Vwd on the word line is varied from a standard range. The examining unit 101 detects the voltage level Vwd out of the standard range as similar to the examining unit 44 and shift a third fail signal DGF3 to an active level. With the third fail signal DGF3, the tri-state output buffer circuit 48g allows the data pin Dout to enter the high impedance state. The examining unit 101 is similar in circuit arrangement to the examining unit 44, and, for this reason, no further description is incorporated for the sake of simplicity.

The examining unit 101 is valuable for a semiconductor memory device having the electric source 45e for boot-strapping a voltage level fed from the outside thereof, because a defect having an influence on the voltage level on the word line tends to takes place in the electric source 45e.

Although particular embodiments of the present invention have been shown and described, it will be obvious to those skilled in the art that various changes and modifications may be made without departing from the scope of the present invention. For example, the semiconductor devices described hereinbefore are of the random access memory, however, the present invention is applicable to a semiconductor memory device of another type such as, for example, an electrically erasable programmable read only memory.

## Claims

1. A semiconductor memory device having a usual mode of operation and a diagnostic mode of operation for detecting a defective portion, comprising: a) a diagnostic mode discriminating unit (42) responsive to external control signals (R̅A̅S̅, C̅A̅S̅, W̅E̅) indicative of a request for said diagnostic mode of operation and for producing a first activation signal (ACT1); b) a memory cell array (45a) having a plurality of memory cells (MC11 and MC21) and an associated plurality of peripheral units (45b, 45c, 45d, 45e, 45f, 45g and 45h) for carrying out said usual mode and said diagnostic mode of operation, said memory cells storing respective data bits, said peripheral units having a conductive portion (ND) having a voltage level (V_{nd}), which voltage level is liable to be affected by a defect; and c) a multi-bit parallel diagnostic unit (43) responsive to said first activation signal and for causing said memory cell array associated with said peripheral units to sequentially supply a plurality of data bit groups each consisting of a predetermined number of said data bits thereto for detecting a defective portion having an influence on said data bits, characterized in that said diagnostic mode discriminating unit further produces a second activation signal (ACT2), and in that said semiconductor memory device further comprises d) voltage level examining means (44 or 101)) responsive to said second activation signal and for comparing the voltage level at said conductive portion with a reference voltage range to see whether or not said defect takes place.

## Patentansprüche

1. Halbleiterspeichervorrichtung mit einem normalen Betriebsmodus und einem Diagnosebetriebsmodus zur Erfassung eines defekten Bereichs mit:
a) einer Diagnosemodus-Unterscheidungseinheit (42), die auf externe Steuersignale (R̅A̅S̅, C̅A̅S̅, W̅E̅) anspricht, die eine Anforderung des Diagnosebetriebsmodus angeben, und zur Erzeugung eines ersten Aktivierungssignals (ACT 1),
b) ein Speicherzellenfeld (45a) mit einer Anzahl von Speicherzellen (MC11 und MC21), und einer Anzahl zugeordneter Peripherieeinheiten (45b, 45c, 45d, 45e, 45f, 45g und 45h) zur Ausführung des normalen Modus und des Diagnosebetriebsmodus, wobei die Speicherzellen jeweils Datenbits speichern und wobei die Peripherieeinheiten einen Leitungsabschnitt (ND) mit einem Spannungspegel (V_{nd}) aufweisen, wobei der Spannungspegel durch einen Defekt beeinflußt werden kann, und
c) einer parallelen Mehrbit-Diagnoseeinheit (43), die auf das erste Aktivierungssignal anspricht und bewirkt, daß das den Peripherieeinheiten zugeordnete Speicherzellenfeld sequentiell eine Anzahl von Datenbitgruppen aus jeweils einer vorgegebenen Zahl von Datenbits dahin ausgibt, zur Erfassung eines defekten Teils, der einen Einfluß auf die Datenbits ausübt, dadurch **gekennzeichnet,** daß die Diagnosemodus-Unterscheidungseinheit ferner ein zweites Aktivierungssignal (ACT 2) erzeugt und daß die Halbleiterspeichervorrichtung ferner aufweist
d) eine Spannungspegel-Prüfeinrichtung (44 oder 101), die auf das zweite Aktivierungssignal anspricht, zum Vergleichen des Spannungspegels in dem leitenden Abschnitt mit einem Bezugsspannungsbereich, um festzustellen, ob ein Defekt vorhanden ist oder nicht.

## Revendications

1. Dispositif de mémoire à semi-conducteur ayant un mode de fonctionnement usuel et un mode de fonctionnement en diagnostic pour détecter une partie défectueuses, comprenant : a) une - unité de discrimination de mode en diagnostic (42) répondant à des signaux de commande externes (R̅A̅S̅, C̅A̅S̅, W̅E̅) représentatifs d'une demande pour ledit mode de fonctionnement en diagnostic et pour produire un premier signal d'activation (ACT1); b) un réseau de cellules de mémoire (45a) ayant une multitude de cellules de mémoire (MC11 et MC21) et une multitude associée d'unités périphériques (45b, 45c, 45d, 45e, 45f, 45g et 45h) pour exécuter ledit mode usuel et ledit mode de fonctionnement en diagnostic, lesdites cellules de mémoire stockant des bits de données respectifs, lesdites unités périphériques ayant une partie conductrice (ND) ayant un niveau de tension (Vnd), niveau de tension qui est à même d'être affecté par un défaut; et c) une unité de diagnostic en parallèle à bits multiples (43) répondant audit premier signal d'activation et pour amener ledit réseau de cellules de mémoire associé auxdites unités périphériques à fournir séquentiellement une multitude de groupes de bits de données, chacun étant constitué d'un nombre prédéterminé desdits bits de données y appartenant afin de détecter une partie défectueuse ayant une influence sur lesdits bits de données,
caractérisé en ce que ladite unité de discrimination de mode de diagnostic produit en outre un second signal d'activation (ACT2), et en ce que ledit dispositif de mémoire à semi-conducteur comporte en outre d) un moyen d'examen de niveau de tension (44 ou 101) répondant audit second signal d'activation et pour comparer le niveau de tension à ladite partie conductrice à une gamme de tensions de référence pour voir si oui ou non ledit défaut se produit.
